Europäisches Patentamt

European Patent Office

Office européen des brevets

(19)

(11) Veröffentlichungsnummer: **0 134 527**
A1

(12) # EUROPÄISCHE PATENTANMELDUNG

(21) Anmeldenummer: **84108816.4**

(22) Anmeldetag: **25.07.84**

(51) Int. Cl.⁴: **H 03 K 19/017**
H 03 K 5/02

(30) Priorität: **11.08.83 DE 3329093**

(43) Veröffentlichungstag der Anmeldung:
**20.03.85 Patentblatt 85/12**

(84) Benannte Vertragsstaaten:
**AT DE FR GB IT**

(71) Anmelder: **Siemens Aktiengesellschaft**
**Berlin und München Wittelsbacherplatz 2**
**D-8000 München 2(DE)**

(72) Erfinder: **Eberhard, Günther, Dipl.-Phys.**
**Herbststrasse 45**
**D-8031 Eichenau(DE)**

(72) Erfinder: **Krause, Joachim, Dipl.-Ing.**
**Johann-Strauss-Strasse 3b**
**D-8011 Vaterstetten(DE)**

(54) **Dynamischer MOS-Schaltkreis.**

(57) Die Erfindung betrifft einen dynamischen MOS-Schaltkreis mit einem vom Ausgangstransistor (3) entkoppelten Bootstrap-Kodensator (10), der über einen MOS-FET (1) entladen ist. Dieser ist als Konstantstromquelle geschaltet. Die Erfindung zeichnet sich dadurch aus, daß die Steuerspannung am Ausgangs-MOS-FET (4) nahezu den doppelten Betrag der Betriebsspannung ($V_{DD}$) erreicht.

FIG 1

SIEMENS AKTIENGESELLSCHAFT  Unser Zeichen  **0134527**

Berlin und München  VPA **83** P 1 5 7 0 E

## Dynamischer MOS-Schaltkreis

Die Erfindung betrifft einen dynamischen MOS-Schaltkreis, bestehend aus einer ersten Reihenschaltung eines ersten Steuer-MOS-FET, eines Entlade-MOS-FET, dessen Drain-Eingang mit einem Bootstrap-Kondensator verbunden ist, und eines ersten Schalt-MOS-FET, und bestehend aus einer nachgeschalteten zweiten Reihenschaltung eines zweiten Steuer-MOS-FET und eines über den Entlade-MOS-FET ansteuerbaren zweiten Schalttransistors.

Ein wichtiges Merkmal eines MOS-Schaltkreises ist bekanntlich sein dynamisches Verhalten. Dazu gehört die Abhängigkeit der Schaltgeschwindigkeit von Lastkapazitäten, wobei sich mit steigender Belastung die Schaltgeschwindigkeit verringert. Ferner ist die Höhe des Ausgangspegels zu beachten, die möglichst nahe an der Betriebsspannung liegen soll. Aus Electronics, June 30, 1981, S. 128 ist ein dynamischer MOS-Schaltkreis bekannt, welcher hohe Lastkapazitäten schaltet und dabei eine Ausgangsspannung aufweist, welche etwa der Betriebsspannung entspricht. Dieser Treiberbaustein besteht aus einem Eingangsinverter und zwei Schaltstufen mit einem vom Eingang des Ausgangstransistors entkoppelten Bootstrap-Kondensator. Bei einem niederwertigen Eingangssignal wird dieser aufgeladen, wobei ein vom Eingangssignal angesteuerter Transistor ein Abfließen der Ladung vermindert. Die Spannung am Kondensator liegt dabei unter der Betriebsspannung. Wenn das Eingangssignal steigt, wird der Ausgangstransistor in Abhängigkeit von der Kondensatorspannung

Lg 1 Gae / 10.08.1983

über den genannten Entladetransistor angesteuert. Nachteilig dabei ist, daß die auf diese Weise erzeugte Steuerspannung in ihrem Maximalwert relativ gering ist. Außerdem ist die Flankensteilheit des Ausgangssignals von der Flankensteilheit des Eingangssignals abhängig. Ein flacher Anstieg wird zwangsläufig vom Eingang auf den Ausgang übertragen. Erwünscht sind jedoch möglichst steile Signalflanken.

Der Erfindung lag daher die Aufgabe zugrunde, einen Schaltkreis der eingangs genannten Art anzugeben, mit welchem Ausgangsimpulse hoher Flankensteilheit und hoher Pegel erzeugt werden.

Diese Aufgabe wird dadurch gelöst, daß der Entlade-MOS-FET als Konstantstromquelle geschaltet ist.

Auf diese Weise wird der Entladevorgang des Bootstrap-Kondensators unabhängig vom Verlauf des Eingangssignals. Außerdem hat die Erfindung den Vorteil, daß eine Steuerspannung für den Ausgangs-MOS-FET erzeugt wird, die annähernd der doppelten Betriebsspannung entspricht. Ferner ist der Schaltungsaufwand verringert, da kein Eingangsinverter erforderlich ist.

Weiterbildungen der Erfindungen ergeben sich aus den Unteransprüchen. Im folgenden wird die Erfindung anhand zweier Ausführungsbeispiele weiter beschrieben.

Fig. 1 und Fig. 2 zeigen jeweils einen MOS-Schaltkreis
Fig. 3 zeigt eine Weiterbildung des Schaltkreises nach
    Fig. 1.

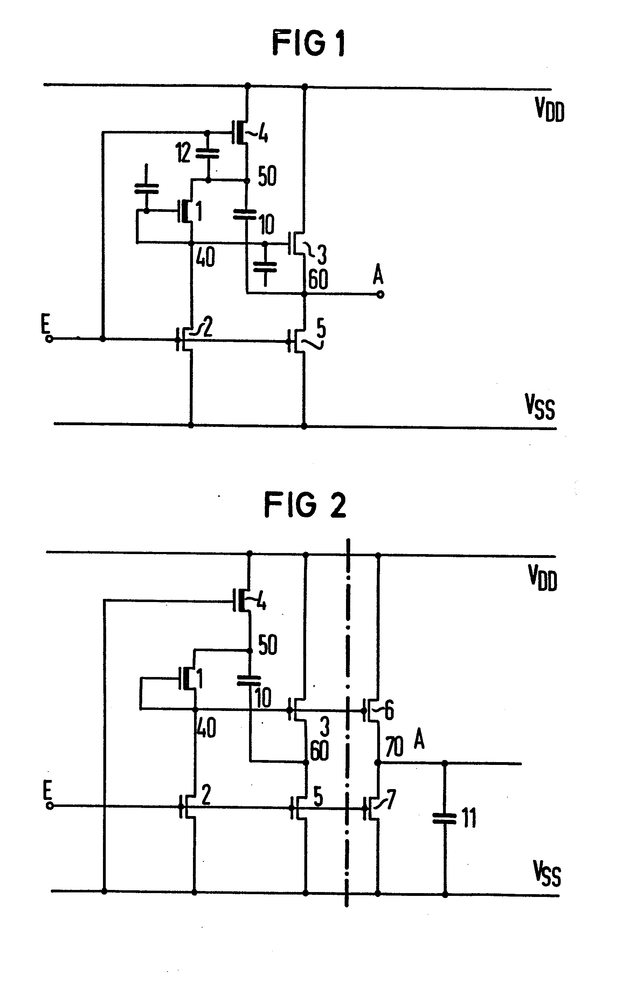

Der Einkanal-MOS-Treiberschaltkreis der Fig. 1 besteht aus einer ersten Reihenschaltung eines ersten Steuer-MOS-FET 2 vom Anreicherungstyp, eines als Konstantstromquelle geschalteten Last-MOS-FET 1 und eines ersten Schalt-MOS-FET 4 jeweils vom Verarmungstyp. Ferner weist er eine zweite Reihenschaltung eines zweiten Steuer-MOS-FET 5 und eines zweiten Schalt-MOS-FET 3 jeweils vom Anreicherungstyp auf. Der Steuereingang des zweiten Schalt-MOS-FET 3 ist mit einem ersten Knoten 40 in der gesteuerten Strecke zwischen dem ersten Steuer-MOS- FET 2 und dem Last-MOS-FET 1 verbunden. Ein Bootstrap-Kondensator 10 verbindet einen zweiten Knoten 50 mit einem dritten Knoten 60, welcher den Ausgang der Schaltung darstellt. Der Knoten 50 liegt in der gesteuerten Strecke zwischen dem Last-MOS-FET 1 und dem ersten Schalt- MOS-FET 4.

Bei einem hochliegenden Eingangssignal E sind die beiden Steuer-MOS-FET 2, 5 leitend und der erste und der dritte Knoten 40, 60 liegen auf einem Bezugspotential nahe $V_{ss}$. Über den ebenfalls vom Eingangssignal E angesteuerten ersten Schalt-MOS-FET 4 wird der Bootstrap-Kondensator 10 und somit der zweite Knoten 50 nahezu auf den Wert einer Betriebsspannung $V_{DD}$ aufgeladen. Der Unterschied zur Betriebsspannung $V_{DD}$ ergibt sich aus den Spannungsabfällen am zweiten Steuer-MOS-FET 5 und am ersten Schalt-MOS-FET 4.

Wechselt das Eingangssignal E auf das Bezugspotential $V_{ss}$, sperren die beiden Steuer-MOS-FETs 2, 5. Die Spannung am ersten Knoten 40 steigt auf den Wert der Spannung am zweiten Knoten 50. Dadurch wird der zweite Schalt-MOS-FET 3 geöffnet. Er bewirkt dadurch ein Ansteigen des dritten Knotens 60 auf die Betriebsspannung $V_{DD}$. Da der erste Schalt-MOS-FET 4 sperrt, setzt sich die Steuerspannung des zweiten Schalt-MOS-FET 3 (Ausgang-MOS-FET) am ersten Knoten 40 aus der Betriebsspannung $V_{DD}$ und

0134527

der am Bootstrap-Kondensator 10 fallenden Spannung zusammen. Der Wert dieser aufsummierten Spannung nähert sich umso mehr dem Wert der doppelten Betriebsspannung $V_{DD}$, je kleiner die schematisch angezeichneten parasitären Kapazitäten am ersten und zweiten Knoten 40, 50 gegenüber der Kapazität des Bootstrap-Kondensators 10 sind.

Durch eine kapazitive Kopplung (Kondensator 12) zwischen dem Eingang des Schaltkreises und dem zweiten Knoten 50 ist eine in manchen Anwendungsfällen gewünschte Flankenverzögerung einstellbar.

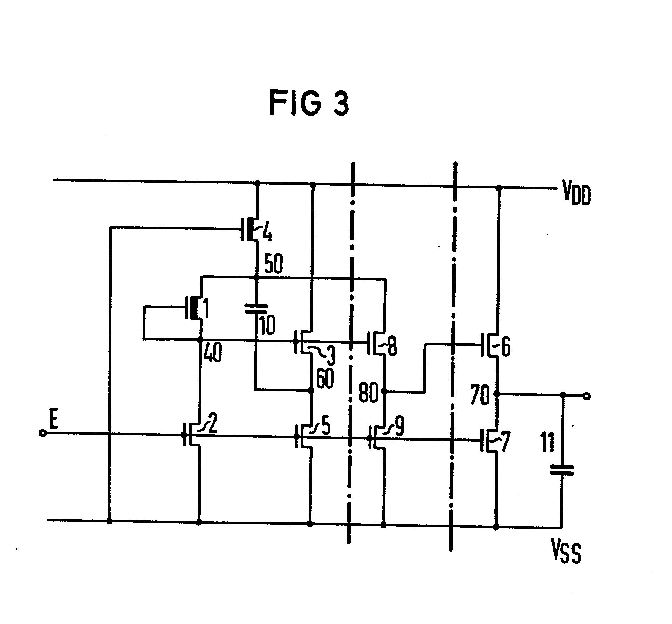

Fig. 2 zeigt einen weiteren Einkanal-MOS-Treiberschaltkreis, mit einer Gegentakt-Ausgangsstufe (MOS-FETs 6, 7 vom Anreicherungstyp). Im Unterschied zum Schaltkreis in Fig. 1 ist der Steuereingang des ersten Schalt-MOS-FET 4 mit dem Bezugspotential $V_{ss}$ beaufschlagt. Ebenso wie der in Fig. 3 wiedergegebene Schaltkreis ist er besonders zum Schalten von höheren kapazitiven Lasten, die als Kondensator 11 dargestellt sind, geeignet. Die Steuerspannung des MOS-FET 6 wird am ersten Knoten 40 abgegriffen. Somit ist der dritte Knoten 60 von der kapazitiven Last 11 entkoppelt. Der Spannungsverlauf des Ausgangssignals A am dritten Knoten 60 folgt somit unmittelbar dem Spannungsverlauf am ersten Knoten 40.

In Fig. 3 ist vor die Gegentakt-Ausgangsstufe eine Treiberstufe, bestehend aus zwei weiteren MOS-FETs 8, 9 vom Anreicherungstyp geschaltet. Die gesteuerte Strecke der in Reihe liegenden weiteren MOS-FETs 8, 9 verbindet den zweiten Knoten 50 mit dem Bezugspotential $V_{ss}$. Auf diese Weise wird der erste Knoten 40 weiter entlastet.

Die Ansteuerung des MOS-FET 6 erfolgt über den gemeinsamen Verbindungspunkt der MOS-FETs 8,9.

In einem weiteren, vorteilhaften Ausführungsbeispiel ist der erste Schalt-MOS-FET 4 vom Anreicherungstyp. Sein Steuereingang ist in diesem Fall fest mit der Betriebsspannung $V_{DD}$ belegt (ohne Figur).

3 Figuren
7 Patentansprüche

## Patentansprüche

1. Dynamischer MOS-Schaltkreis, bestehend aus einer ersten Reihenschaltung eines ersten Steuer-MOS-FET, eines Entlade-MOS-FET, dessen Drain-Eingang mit einem Bootstrap-Kondensator verbunden ist, und eines ersten Schalt-MOS-FET, und bestehend aus einer nachgeschalteten zweiten Reihenschaltung eines zweiten Steuer-MOS-FET und eines über den Entlade-MOS-FET ansteuerbaren zweiten Schalt-transistors, d a d u r c h   g e k e n n z e i c h n e t, daß der Entlade-MOS-FET (1) als Konstantstromquelle geschaltet ist.

2. MOS-Schaltkreis nach A 1, g e k e n n z e i c h n e t durch einen Kondensator (12) zwischen dem Eingang des Schaltkreises und dem Source-Eingang des Entlade-MOS-FET (1).

3. MOS-Schaltkreis nach einem der A 1 oder A 2, d a - d u r c h   g e k e n n z e i c h n e t, daß der erste Steuer-MOS-FET (2) vom Anreicherungstyp und der erste Schalt-MOS-FET (4) vom Verarmungstyp ist, dessen Steuereingang mit dem Eingang des Schaltkreises verbunden ist.

4. MOS-Schaltkreis nach einem der A 1 oder A 2, d a - d u r c h   g e k e n n z e i c h n e t, daß der erste Steuer-MOS-FET (2) vom Anreicherungstyp und der erste Schalt-MOS-FET (4) vom Verarmungstyp sind, und daß der Steuereingang des ersten Schalt-MOS-FET (4) mit einem Bezugspotential ($V_{SS}$) belegt ist.

5. MOS-Schaltkreis nach einem der A1 oder A2, d a - d u r c h   g e k e n n z e i c h n e t, daß der erste Steuer-MOS-FET (2) und der erste Schalt-MOS-FET (4) vom Anreicherungstyp sind, und daß der Steuereingang des ersten Schalt-MOS-FET (4) mit einer Betriebsspannung ($V_{DD}$) belegt ist.

6. MOS-Schaltkreis nach einem der vorhergehenden Ansprüche, g e k e n n z e i c h n e t  durch eine Gegentakt-Ausgangsstufe.

7. MOS-Schaltkreis nach Anspruch 5, g e k e n n z e i c h n e t  durch eine Treiberstufe vor der Gegentakt-Ausgangsstufe.

0134527

## FIG 1

## FIG 2

FIG 3

Europäisches Patentamt

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| X | EP-A-0 045 133 (INMOS CORP.) <br> * Seite 5, Zeile 31 - Seite 7, Zeile 14 * | 1,6 | H 03 K 19/017 <br> H 03 K 5/02 |
| A | US-A-4 071 783 (KNEPPER) <br> * Spalte 5, Zeilen 15-58 * | 1,3,6 | |
| A | IBM TECHNICAL DISCLOSURE BULLETIN, Band 19, Nr. 3, August 1976, Seiten 827-828, New York, USA; T.V. HARROUN: "Bootstrap inverter driver" <br> * Insgesamt * | 1,7,6 | |
| A | IBM TECHNICAL DISCLOSURE BULLETIN, Band 24, Nr. 10, März 1982, Seiten 5055-5056, New York, USA; J.A. GABRIC et al.: "MOSFET self-bootstrapping inverter driver circuit" <br> * Insgesamt * | 1 | RECHERCHIERTE SACHGEBIETE (Int. Cl.4) <br><br> H 03 K |
| A | US-A-4 042 838 (STREET et al.) <br> * Spalte 5, Zeilen 3-45 * | 1 | |

Der vorliegende Recherchenbericht wurde für alle Patentansprüche erstellt.

| Recherchenort <br> DEN HAAG | Abschlußdatum der Recherche <br> 31-10-1984 | Prüfer <br> KERN H. |
|---|---|---|